# EUROPEAN PATENT APPLICATION

(11) **EP 2 001 056 A2**
(43) Date of publication of application: **10.12.2008**
(21) Application number: 07738935.1
(22) Date of filing: 19.03.2007
(51) Int. Cl.: H01L 31/042, H01L 31/04

(54) **BACKSIDE PROTECTIVE SHEET FOR SOLAR BATTERY MODULE**

(30) Priority: 28.03.2006 JP 2006089051
(71) Applicant: Toray Advanced Film Co., Ltd., Chuo-ku Tokyo 103-0021 (JP)
(72) Inventor: TERANISHI, Masayoshi, Sunto-gun, Shizuoka 411-0931 (JP); MIKAWA, Masahiro, Mishima-shi, Shizuoka 411-0822 (JP)
(74) Representative: Kador & Partner
(86) International application number: PCT/JP2007/055490
(87) International publication number: WO 2007/122936

(57) **Abstract**

This invention provides a backside protective sheet for a solar battery module. The protective sheet is formed of a laminated material comprising an alumina vapor-deposited polyester film, a white polyester film, and a polyester film, of which the tensile elongation can be maintained at not less than 60% in both machine direction and transverse direction of the film as measured after storage for 10 hr in such a state that the film is exposed to a high pressure steam of 140°C, stacked in that order on top of each other and the shrinkage upon heat treatment at 150°C for 30 min is not more than 0.5% in both machine direction and transverse direction. The backside protective sheet for a solar battery module has no significant moisture absorption-derived lowering in power generating properties of the module, can effectively reflect incident light for reutilization, and can enhance power conversion efficiency of the solar battery.

## Description

### TECHNICAL FIELD

The present invention relates to a backside protection sheet for a module for a solar cell.

### BACKGROUND ART

A solar cell is being put to practical use as a semipermanent and pollution-free new energy source. In recent years, the solar cell is in the spotlight as a next-generation energy source. The solar cells are applied to a building area and electric and electronic parts based on the solar cell are increasingly developed.

As a solar cell module, a solar cell module comprising a surface protection sheet, an adhesive resin layer, a photovoltaic element, an adhesive resin layer, and a backside protection sheet is widely known.

Recently, solar cells utilizing semiconductor devices of amorphous silicon or the like are coming into wide use rapidly, and come to be used as a power source for conventional home.

When the solar cell and roof materials are combined into one to be used, it is common that a plurality of solar cell elements are used as a solar cell module formed by combining a plurality of solar cell elements and protecting a front face and a rear faces of combined elements with proper covering materials. As a backside protection sheet of the solar cell, a method of stacking a light reflective film, an oxide vapor deposited layer, and a hydrolysis-resistant polyester film is also proposed (refer to Patent Documents 1 to 3).

A steam-blocking property is required of both the surface protection sheet and the backside protection sheet of the solar cell, but there was a problem that in the case where a sheet is constructed by use of vapor deposition of aluminum oxide, shrinkage of the sheet occurs in thermocompression bonding the protection sheet to a solar cell module and therefore a steam-blocking property is deteriorated, and thereby power generation performance of the module is deteriorated.
Patent Document 1: Japanese Unexamined Patent Publication No.2000-114564
Patent Document 2: Japanese Unexamined Patent Publication No.2000-114565
Patent Document 3: Japanese Unexamined Patent Publication No.2002-100788

### DISCLOSURE OF THE INVENTION

The present invention pertains to a backside protection sheet for a solar cell module comprising a stacked material formed by successively stacking an alumina vapor deposited polyester film, a white polyester film and a polyester film in which 60% or more of tensile elongation is maintained in both a machine direction and a transverse direction of the film after the film is stored in high-pressure steam of 40ºC for 10 hours, wherein a shrinkage percentage of the backside protection sheet at a time of heat-treating at 150ºC for 30 minutes is 0.5% or less in both a machine direction and a transverse direction.

### BRIEF DESCRIPTION OF THE DRAWINGS

Fig. 1 is a sectional view illustrating a module for a solar cell of the present invention,
Fig. 2 is a sectional view illustrating a backside protection sheet for a module for a solar cell of the present invention, and
Fig. 3 is a sectional view illustrating an alumina vapor deposited polyester film.

### DESCRIPTION OF THE REFERENCE NUMERALS AND SYMBOLS

1: surface protection sheet
2: photovoltaic element
3: adhesive resin layer
4: backside protection sheet
5: white polyester film
6: polyester film in which 60% or more of tensile elongation is maintained in both a machine direction and a transverse direction of the film after the film is stored in high-pressure steam of 140ºC for 10 hours
71: alumina vapor deposited polyester film
711: resin coat layer
712: inorganic oxide vapor deposited thin film layer
713: polyester film

### BEST MODE FOR CARRYING OUT THE INVENTION

The present invention pertains to a backside protection sheet for a solar cell module comprising a stacked material formed by successively stacking an alumina vapor deposited polyester film, a white polyester film and a polyester film in which 60% or more of tensile elongation is maintained in both a machine direction and a transverse direction of the film after the film is stored in high-pressure steam of 140ºC for 10 hours, wherein a shrinkage percentage of the backside protection sheet at a time of heat-treating at 150ºC for 30 minutes is 0.5% or less in both a machine direction and a transverse direction.

The backside protection sheet for a solar cell of the present invention constitutes a solar cell module. The backside protection sheet for a solar cell of the present invention will be described by use of drawing.

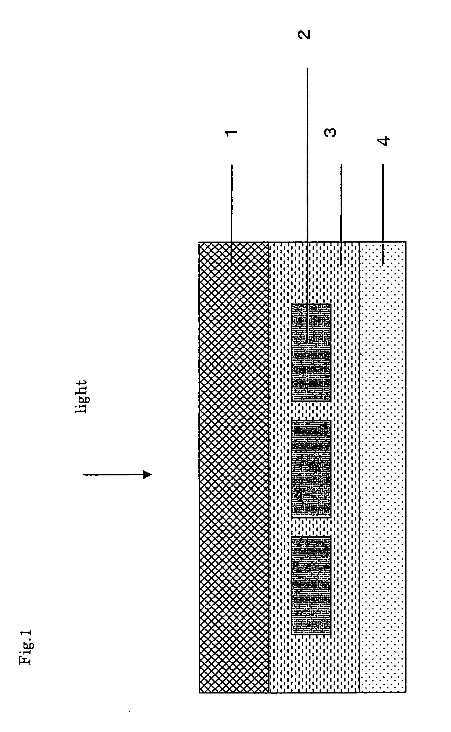

Fig. 1 is a sectional side elevation view illustrating a stacked structure of an embodiment of the backside protection sheet for a solar cell of the present invention. The stacked structure is composed of a surface protection sheet 1, a photovoltaic element 2, an adhesive resin layer 3, and a backside protection sheet 4. External light enters the surface protection sheet, passes through the adhesive resin layer 3, and reaches the photovoltaic element 2 to generate an electromotive force. Further, light reflected off the backside protection sheet reaches the photovoltaic element 2 to generate an electromotive force.

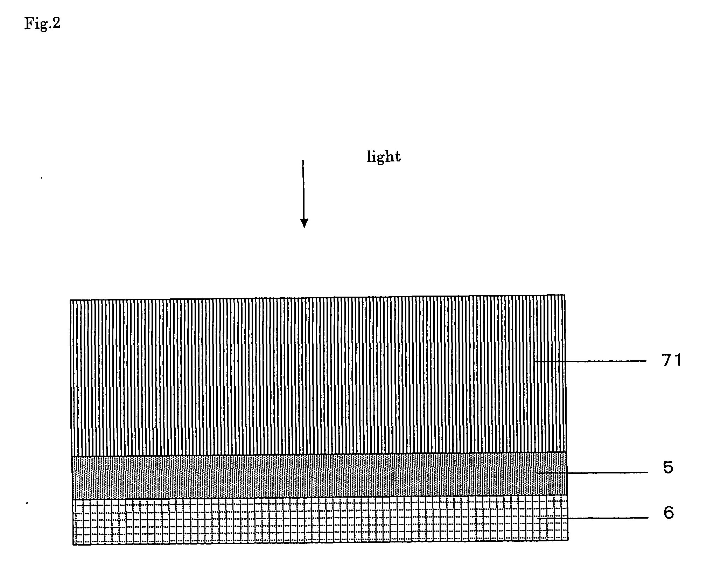

Fig. 2 is a sectional schematic view showing an example of a backside protection sheet for a solar cell module. In this protection sheet, a transparent alumina vapor deposited polyester film, a white polyester film and a polyester film, in which 60% ormore of tensile elongation is maintained in both amachine direction and a transverse direction of the film after the film is stored in high-pressure steam of 140ºC for 10 hours, are stacked in this order from a face subjected to light irradiation.

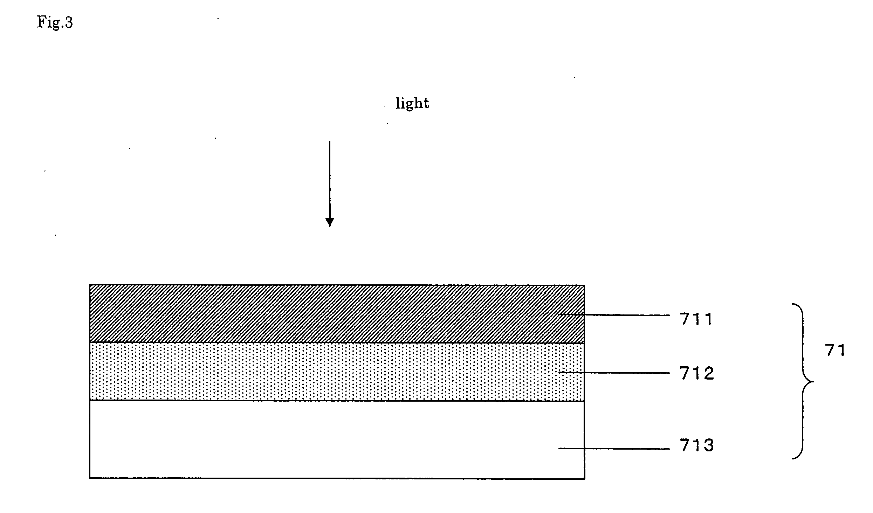

Fig. 3 is a sectional schematic view showing an example of an alumina vapor deposited polyester film. In this film, an alumina vapor deposited thin film layer and a polymer polyester film are successively stacked.

In the backside protection sheet for a solar cell module of the present invention, the alumina vapor deposited polyester film is used for the purpose of making the whitening/yellowing and the reduction in strength and elongation of a member constituting a solar cell module in a long-term use hardly occur or for the purpose of making the deterioration of power generation efficiency due to the moisture absorption of a solar cell module hardly occur.

In the backside protection sheet for a solar cell module of the present invention, the alumina vapor deposited polyester film desirably has steam permeability at a temperature of 40ºC and at a relative humidity of 90% of 1. 5 g/m²·day or less, and a plurality of the alumina vapor deposited polyester films may also be used depending on a required steam-blocking property. An easily adhesive coat can be formed on the surface of the alumina vapor deposited polyester film on which alumina is not vapor deposited to improve an adhesive force to the adhesive resin layer constituting the solar cell module. The steam permeability at a temperature of 40ºC and at a relative humidity of 90% is more preferably 1 g/m²·day or less

In the backside protection sheet for a solar cell module of the present invention, the alumina vapor deposited polyester film is preferably an alumina vapor deposited polyethylene terephthalate film. Furthermore, as the alumina vapor deposited polyester film, a biaxially stretched film of polyethylene terephthalate is preferably used from the viewpoint of processability, transparency, heat resistance and price.

In the backside protection sheet for a solar cell module of the present invention, an alumina vapor deposited polyester film is preferably a transparent alumina vapor deposited polyester film having total light transmittance of 85% or more.

In the backside protection sheet for a solar cell module of the present invention, as the polyester film used for the transparent alumina vapor deposited polyester film, polyethylene terephthalate is preferably used. The polyester film may contain various additives , and examples of the additives include an antistatic agent, a UV absorber and a stabilizer.

Further, in the backside protection sheet for a solar cell module of the present invention, it is desirable not to include inert particles for providing a slipping property in the alumina vapor deposited polyester film from the viewpoint of transparency.

In the backside protection sheet for a solar cell module of the present invention, even an article formed by combining a coat with an aluminum oxide vapor deposited thin film can be used for the alumina vapor deposited polyester film.

In the backside protection sheet for a solar cell module of the present invention, as a method of forming an alumina vapor deposited thin film layer of the alumina vapor deposited polyester film, a vacuum deposition method, a sputtering method, and an ion-plating method can be employed, but the vacuum deposition method is suitably used.

When taking the total light transmittance of a base film not yet vapor deposited as 100, an alumina vapor deposited thin film is formed preferably so as to have total light transmittance of 99.8 or less, the deterioration of a steam-blocking property of the film due to heat shrinkage is inhibited. When the alumina vapor deposited thin film layer is formed so as to have the same total light transmittance as that of the base film not yet vapor deposited, the vapor deposited thin film is clear and colorless, but the film is very brittle and the steam-blocking property of the film may be deteriorated due to film shrinkage in a heat treatment. By forming the alumina vapor deposited thin film preferably so as to have total light transmittance of 99.8 or less taking the total light transmittance of the base film not yet vapor deposited as 100, it is possible to leave an aluminum metal portion in the vapor deposited thin film and improve a drawing property of the vapor deposited film. By forming the alumina vapor deposited thin film so as to have total light transmittance of 99.8 or less, it becomes more possible to minimize the deterioration of the steam-blocking property even when the film is shrunk by 0.5%.

In the backside protection sheet for a solar cell module of the present invention, an aluminum oxide film of the alumina vapor deposited polyester film is preferably produced under the condition in which the ratio (B/A) of an amount [mol/min] of introduced oxygen gas and an average amount A [mol/min] of evaporated aluminum per unit time is 0.6 or more and 0.72 or less (0.6 = B/A = 0.72). When the ratio (B/A) of an amount [mol/min] of introduced oxygen gas and an average amount A [mol/min] of evaporated aluminum per unit time is 0.6 or more and 0.72 or less (0.6 = B/A = 0.72), it is preferable since the deterioration of the steam permeability is inhibited in stacking the solar cell module and the backside protection sheet by heat-melting them and attaching them to each other by pressure. The ratio (B/A) of an amount [mol/min] of introduced oxygen gas and an average amount A [mol/min] of evaporated aluminum per unit time is more preferable 0.6 or more and 0.7 or less.

In the backside protection sheet for a solar cell module of the present invention, a resin coat layer may be formed on the alumina vapor deposited thin film for the purpose of improving a steam-blocking property. A thickness of a coat of the resin coat layer in the case of forming the resin coat layer on the alumina vapor deposited thin film is preferably 0.2 to 2.0 µm. When the thickness of a coat of the resin coat layer is 0.2 to 2.0 µm, occurrence of scratch due to abrasion on the face of an inorganic oxide vapor deposited thin film layer due to a roll in a production process is not produced and a gas barrier property is not deteriorated. Furthermore, when the thickness of a coat of the resin coat layer is 0.2 to 2.0 µm, transparency is not deteriorated and blocking does not occur.

In the backside protection sheet for a solar cell module of the present invention, the white polyester film is preferably a white polyethylene terephthalate film. Furthermore, as the white polyester film, a biaxially stretched film of polyethylene terephthalate is preferably used from the viewpoint of processability, transparency, heat resistance and price.

In the backside protection sheet for a solar cell module of the present invention, the white polyester film is used in order to reflect solar light and enhance power generation efficiency. The white polyester film is preferably a polyester film having a reflection factor of 30% or more at a wavelength λ of 550 nm, more preferably a polyester film having a reflection factor of 40% or more, and furthermore preferably a polyester film having a reflection factor of 50% or more.

In the backside protection sheet for a solar cell module of the present invention, it is preferable to use a polyester film formed by including minute air bubbles in a polyester film as the white polyester film.

In the backside protection sheet for a solar cell module of the present invention, when a color of the polyester film is changed to white for obtaining a white polyester film, a white additive such as titanium oxide, silica, alumina, calcium carbonate, barium sulfate or the like is preferably added. In order to further enhance a whiteness degree, it is effective to use a fluorescent brightener such as thiophenediyl.

It is necessary to use a polyester film in which 60% or more of tensile elongation is maintained in both a machine direction and a transverse direction of the film after the film is stored in high-pressure steam of 140ºC for 10 hours for the backside protection sheet for a solar cell module of the present invention.

In common polyester, a carboxyl end group plays a catalytic role and hydrolysis is advanced by an attack of a water molecule on an ester bond. Since terephthalic acid and ethylene glycol are produced by this hydrolysis and therefore film properties such as tensile strength and tensile elongation are degraded, impact resistance is deteriorated. A film which maintains elongation at break of a certain value or more in order to prevent the deterioration of impact resistance even after the film is stored in a forced humidified condition is generally a polyester film having hydrolysis-resistant performance.

In the backside protection sheet for a solar cell module of the present invention, as a polyester film having hydrolysis-resistant performance, a polyester film, in which 60% ormore of tensile elongation is maintained in both amachine direction and a transverse direction of the film after the film is stored in high-pressure steam of 140ºC for 10 hours, is used.

As an example of the polyester film, in which 60% or more of tensile elongation is maintained in both a machine direction and a transverse direction of the film after the film is stored in high-pressure steam of 140ºC for 10 hours, a polyester film, in which a time in which elongation at break of the polyester film stored in high-pressure steam of 140ºC, measured according to JIS C 2151 (1996), is reduced by 50% compared to that measured before being stored in high-pressure steam of 140ºC, is over two times more than a film not having hydrolysis resistance, is placed on the market, and this polyester film is preferable. As the polyester film in which 60% or more of tensile elongation is maintained in both a machine direction and a transverse direction of the film after the film is stored in high-pressure steam of 140ºC for 10 hours, a biaxially stretched film of polyethylene terephthalate is preferably used from the viewpoint of processability, transparency, heat resistance and price.

In the backside protection sheet for a solar cell module of the present invention, the polyester film, in which 60% or more of tensile elongation is maintained in both a machine direction and a transverse direction of the film after the film is stored in high-pressure steam of 140ºC for 10 hours, is stacked next to the transparent alumina vapor deposited polyester film and the white polyester film.

In the backside protection sheet for a solar cell module of the present invention, the polyester film, in which 60% or more of tensile elongation is maintained in both a machine direction and a transverse direction of the film after the film is stored in high-pressure steam of 40ºC for 10 hours, is preferably located at the outermost surface layer on the side opposite to the face subjected to light irradiation and reflecting light.

Preferably, the polyester film, in which 60% or more of tensile elongation is maintained in both a machine direction and a transverse direction of the film after the film is stored in high-pressure steam of 140ºC for 10 hours, is highly transparent and rich in flexibility, and has performance of excellent heat resistance, moisture-proof property and hydrolysis resistance, and it has a role to protect a solar cell module.

In the backside protection sheet for a solar cell module of the present invention, a resin layer, to which various publicly known additives such as a heat stabilizer, a lubricant, an antistatic agent, an anti-blocking agent, a dye, a pigment, a photosensitizer, a surfactant and an ultraviolet absorber are added as required, can be stacked.

In the backside protection sheet for a solar cell module of the present invention, a resin layer, which contains various publicly known additives such as a heat stabilizer, a lubricant, an antistatic agent, an anti-blocking agent, a dye, a pigment, a photosensitizer, a surfactant and an ultraviolet absorber, can be stacked.

A shrinkage percentage of the backside protection sheet for a solar cell module of the present invention is 0.5% or less in both a machine direction and a transverse direction when the backside protection sheet is heat-treated at 150ºC for 30 minutes.

When the solar cell module and the backside protection are stacked, they are generally integrated into one by heat-melting the adhesive resin layer, attaching the adhesive resin layer to them by pressure and cooling the resulting stacked body.
Heat-melting and attaching by pressure are generally performed at a temperature of 130 to 150ºC for about 30 minutes. In consideration of the conditions of heat-melting, it is necessary to restrict the shrinkage percentage of the backside protection sheet for a solar cell module of the present invention in a heat treatment performed at 150ºC for 30 minutes to 0.5% or less in both a machine direction and a transverse direction.

When the heat shrinkage percentage of the backside protection sheet for a solar cell module is large, there may be cases where a dimension of the backside protection sheet does not agree with a dimension as a module. When the heat shrinkage percentage of the backside protection sheet for a solar cell module is large, a vapor deposited thin film with an alumina of inorganic oxide is cracked due to a film-shrinkage stress, and therefore a steam-blocking property is deteriorated and solar power generation is impaired.

The shrinkage percentage of the backside protection sheet for a solar cell module in a heat treatment performed at 150ºC for 30 minutes is preferably 1.0% or less in a machine direction and 1.0% or less in a transverse direction, and more preferable 0.5% or less in a machine direction and 0.5% or less in a transverse direction.

As a method of restricting the shrinkage percentage of the backside protection sheet for a solar cell module in a heat treatment performed at 150ºC for 30 minutes to 0.5% or less in both a machine direction and a transverse direction, a technique, in which a film to be processed is shrunk by heating the film in advance by an anneal treatment and thereby shrinkage in the steps such as a step of laminating and a step of thermocompression bonding where heat is added is prevented in the following step, is known.

An increase rate of the steam permeability of the backside protection sheet for a solar cell module between before a heat treatment performed at 150ºC for 30 minutes and after the heat treatment is preferably less than 30%, and more preferable less than 10%.

In the backside protection sheet for a solar cell module of the present invention, it is preferable to stack the alumina vapor deposited polyester film, the white polyester film and the polyester film in which 60% or more of tensile elongation is maintained in both a machine direction and a transverse direction of the film after storing the film in high-pressure steam of 140ºC for 10 hours to bond these films to one another. As a method of bonding these films to one another, a method, in which after an adhesive is applied to one film, this film is overlaid on the other film and bonded to the other film under pressure or by the application of heat, can be employed.

Typical examples of adhesives to be used for bonding the alumina vapor deposited polyester film, the white polyester film and the polyester film in which 60% ormore of tensile elongation is maintained in both a machine direction and a transverse direction of the film after storing the film in high-pressure steam of 140ºC for 10 hours to one another include an acrylic resin, a urethane resin, an epoxy resin, a polyester resin, polyamide, phenol, polyolefin, ionomer, an ethylene-vinyl acetate copolymer, polyvinyl acetal, and copolymers thereof and mixture thereof.

As the adhesive, the urethane resin, the polyester resin, polyolefin, and ionomer are preferable from the viewpoint of an adhesive force and a gas barrier property, and most preferably the urethane resin.

When a thickness of the adhesive is 0.1 to 10 µm, it is preferable in point of the adhesive force and the gas barrier property. The thickness of the adhesive is more preferably 0.3 to 8 µm, and particularly preferably 0.5 to 5 µm.

Particularly when the thickness of the adhesive is 0.5 to 5 µm, an excellent gas barrier property and strong adhesion can be exhibited even when a metal oxide layer has pinholes or minute cracks.

As a constitution of the solar cell module, a constitution of a surface protection sheet, an adhesive resin layer, a photovoltaic element, an adhesive resin layer and a backside protection sheet is widely known, as shown in Fig. 1.

The backside protection sheet for a solar cell module is generally integrated into a solar cell module by stacking the resin adhesive layer, the photovoltaic element, the resin adhesive layer and the surface protection sheet on the backside protection sheet, and heat-melting the adhesive resin layer, attaching the adhesive resin layer to other layers by pressure and cooling the module.

The resin adhesive layer of the solar cell module is used for the purpose of covering the projections and depressions of the photovoltaic element, protecting the photovoltaic element from temperature change, moisture and impact, and securing the adhesion of the element to the surface protection sheet for a solar cell module. As the resin adhesive layer of the solar cell module, a publicly known adhesive film can be used, and examples of materials of the adhesive film include an ethylene-vinyl acetate copolymer, an ethylene-methyl acrylate copolymer, an ethylene-ethyl acrylate copolymer, a urethane resin, polyvinyl butyral, polyvinyl butyral, an ethylene-vinyl acetate partially saponified product, a silicone resin, and polyester resins. As the resin adhesive layer of the solar cell module, ethylene-vinyl acetate is particularly preferably used from the viewpoint of light resistance, permeability, moisture resistance and cost efficiency, and ethylene-vinyl acetate containing 15 to 40% vinyl acetate is particularly preferable. When the content of vinyl acetate of the resin adhesive layer of the solar cell module is 15 to 40%, the transparency of the resin adhesive layer is not reduced and there is no stickiness of a resin, and therefore the resin adhesive layer has good processability and handling property.

A crosslinking agent such as organic peroxide or the like and an additive such as an ultraviolet absorber, an antioxidant or the like can be used for the resin adhesive layer of the solar cell module as required. A resin sheet to which embossing is previously applied may be used in order to mitigate wrinkles in heat-melting and improve processability.

The backside protection sheet for a solar cell module of the present invention inhibits the deterioration of a steam-blocking property at a time of thermocompression bonding the backside protection sheet to the solar cell module.

The backside protection sheet for a solar cell module of the present invention is low in shrinkage in thermocompression bonding the backside protection sheet to the solar cell module.

The backside protection sheet for a solar cell module of the present invention has small deterioration of power generation performance of a module due to moisture absorption, reflects incident light effectively to reuse the reflected light to enhance power conversion efficiency of the solar cell.

Since the backside protection sheet for a solar cell module of the present invention particularly reflects incident light effectively to reuse the reflected light to enhance power conversion efficiency of the solar cell, it is a backside protection sheet for a solar cell module which is superior in the reflection of sunbeam.

### Examples

Hereinafter, the present invention will be described by way of examples. "Part(s)" in Examples and Comparative Examples refers to "part(s) by weight" of solid matter and "%" refers to "% by weight" , unless otherwise specified. Characteristic values of the present invention in Examples and Comparative Examples are obtained according the following measuring methods and evaluation criteria.

Adhesive layers in Examples and Comparative Examples were prepared by applying a urethane adhesive layer (mixture of 10 parts of AD503 produced by Toyo-Morton, Ltd. and 1 part of an isocyanate curing agent CAT-10 produced by Toyo-Morton, Ltd.) to one material in such a way that a dried film thickness is 3 µm, drying the adhesive layer at 80ºC for 2 minutes in an oven of hot air circulation type, bonding the dried layer to other constituent material to stack the dried layer on other constituent material, and curing/aging the stacked one in an oven of 40ºC for 48 hours.

### (1) Steam permeability

The steam permeability was measured under the conditions of 40ºC and a relative humidity of 90% according to JIS K 7129B "Plastics --Film and sheeting -- Determination of water vapour transmission rate -- Instrumental method" established on Aug. 1st, 1992 using PERMATRAN W-TWIN manufactured by MOCON, Inc.

### (2) Total light transmittance

Transmittance by white light (A light defined in JIS Z 8701 "Colour specification -- The CIE 1931 standard colorimetric system and the CIE 1964 supplementary standard colorimetric system" established on Aug. 25th, 1952) was measured using an integrating sphere type haze meter SEP-H-S manufactured by Nippon Seimitsu Kogaku Co., Ltd.

### (3) Heat shrinkage percentage

The backside protection sheet for a solar cell module was heat-treated at 150ºC for 30 minutes in an oven P-212 manufactured by TABAI ESPEC Corp. A heat shrinkage percentage was measured before and after heat treatment using a digital vernier calipers manufactured by MITUTOYO Corp.

### (4) Thickness of aluminum oxide vapor deposited film

A sectional photograph of a film was taken with a transmission electron microscope H-7100FA manufactured by Hitachi, Ltd., and a film thickness on a photograph was measured and an actual film thickness was determined from a magnification of the microphotograph.

### (5) Reflection factor

A reflection factor at a wavelength of 550 nm was determined for both sides of a film in a state of attaching a ø 60 mm integrating sphere 130-063 (manufactured by Hitachi, Ltd.) and a 10º inclined spacer to a spectrophotometer U-3410 (manufactured by Hitachi, Ltd.), and a maximum reflection factor was considered as a reflection factor of the film. As a standard white plate, a plate (manufactured by Hitachi, Ltd.) attached to U-3410 was used.

### (6) Retention of tensile elongation of film stored in high-pressure steam of 140ºC

According to a method described in JIS C 2151 (1996), a test piece of 150 mm long and 15 mm wide was used and a chuck distance was set at 100 mm, and tensile elongation of a film was measured at a tensile speed of 500 mm/min.

Further, according to a method described in JIS C 2151 (1996), a test piece of 150 mm long and 15 mm wide was used and a chuck distance was set at 100 mm, and tensile elongation of a film stored in high-pressure steam of 140ºC for a predetermined time period was measured at a tensile speed of 500 mm/min.

Retention of tensile elongation of a film was determined from the tensile elongation of a film measured before being stored in high-pressure steam of 140ºC and the tensile elongation of a film measured after and before being stored in high-pressure steam of 140ºC.

### Example 1

In order to prepare a transparent alumina vapor deposited polyester film, a biaxially stretched polyethylene terephthalate film T-705 (width 1000 mm, length 4000 mm) having a thickness of 12 µm produced by Toray Industries, Inc. was treated at a drying temperature of 160ºC for 60 seconds using a film coater manufactured by OKAZAKI MACHINE INDUSTRY Co., Ltd. and then the film was heat-treated at 150ºC for 30 minutes to obtain a yet-to-be-vapor deposited film having a shrinkage percentage of 0.2%. Thereafter, a vapor deposited film was formed by reactively depositing an aluminum oxide film having a thickness of 20 nm on the film at a processing rate of 100 m/min in a vacuum of 2×10⁻² Pa using a continuous type vacuum vapor deposition apparatus manufactured by ULVAC, Inc. In the reactive deposition of an aluminum oxide film, the ratio (B/A) between an amount [mol/min] of introduced oxygen gas and an average amount A [mol/min] of evaporated aluminum per unit time was set at 0.6, and an alumina vapor deposited PET film having total light transmittance of 98 was formed when the total light transmittance of a PET film (polyethylene terephthalate film) not yet vapor deposited is taken as 100.

As the white polyester film, 50 µm E20 (width 1000 mm, length 4000 mm) produced by Toray Industries, Inc. was used and treated at a drying temperature of 160ºC for 60 seconds using a film coater manufactured by OKAZAKI MACHINE INDUSTRY Co., Ltd. A shrinkage percentage of this white polyester film was 0.2% after being heat-treated at 150ºC for 30 minutes and a reflection factor at a wavelength λ of 550 nm was 89%.

As the polyester film in which 60% or more of tensile elongation is maintained in both a machine direction and a transverse direction of the film after the film is stored in high-pressure steam of 140ºC for 10 hours, 188 µm X10S (width 1000 mm, length 4000 mm) produced by Toray Industries, Inc. , in which 80% of tensile elongation is maintained in both a machine direction and a transverse direction of the film after the film is stored in high-pressure steam of 140ºC for 10 hours, was used.

This film was treated at a drying temperature of 160ºC for 60 seconds using a film coater manufactured by OKAZAKI MACHINE INDUSTRY Co., Ltd to obtain a film, a shrinkage percentage of which becomes 0.2% after being heat-treated at 150ºC for 30 minutes.

A vapor deposited surface of the transparent alumina vapor deposited polyester film was faced toward and bonded to a white polyester film, andtothis, 188 µmX10S produced by Toray Indus tries, Inc. was bonded, and the resulting bonded film was cured and aged for 48 hours in an oven of 40ºC and then heat-treated at 150ºC for 30 minutes to prepare a backside protection sheet for a solar cell module of Example 1. A shrinkage percentage of the backside protection sheet for a solar cell module of Example 1 measured after being heat-treated at 150ºC for 30 minutes is shown in Table 1.

### Example 2

A backside protection sheet of Example 2 by following the same procedure as in Example 1 except that in vapor deposition of an aluminum oxide film of the transparent alumina vapor deposited polyester film, the ratio (B/A) between an amount [mol/min] of introduced oxygen gas and an average amount A [mol/min] of evaporated aluminum per unit time was set at 0.7, and an alumina vapor deposited film having total light transmittance of 99.8 was formed when the total light transmittance of a polyester film not yet vapor deposited is taken as 100.

### Example 3

A backside protection sheet of Example 3 by following the same procedure as in Example 1 except that in vapor deposition of an aluminum oxide film of the transparent alumina vapor deposited polyester film, the ratio (B/A) between an amount [mol/min] of introduced oxygen gas and an average amount A [mol/min] of evaporated aluminum per unit time was set at 0.72, and an alumina vapor deposited film having total light transmittance of 100 was formed when the total light transmittance of a PET film (polyethylene terephthalate film) not yet vapor deposited is taken as 100.

### Example 4

In order to prepare a transparent alumina vapor deposited polyester film, a biaxially stretched polyethylene terephthalate film T-705 (width 1000 mm, length 4000 mm) having a thickness of 12 µm produced by Toray Industries, Inc. was treated at a drying temperature of 160QC for 20 seconds using a film coater manufactured by OKAZAKI MACHINE INDUSTRY Co., Ltd. and then the film was heat-treated at 150ºC for 30 minutes to obtain a yet-to-be-vapor deposited film having a shrinkage percentage of 0.5%. Thereafter, a vapor deposited filmwas formed by reactively depositing an aluminum oxide film having a thickness of 20 nm on the film at a processing rate of 100 m/min in a vacuum of 2×10⁻² Pa using a continuous type vacuum vapor deposition apparatus manufactured by ULVAC, Inc. In the reactive deposition of an aluminum oxide film, the ratio (B/A) between an amount [mol/min] of introduced oxygen gas and an average amount A [mol/min] of evaporated aluminum per unit time was set at 0.6, and an alumina vapor deposited PET film having total light transmittance of 98 was formed when the total light transmittance of a PET film (polyethylene terephthalate film) not yet vapor deposited is taken as 100.

As the white polyester film, 50 µm E20 (width 1000 mm, length 4000 mm) produced by Toray Industries, Inc. was used and treated at a drying temperature of 160ºC for 20 seconds using a film coater manufactured by OKAZAKI MACHINE INDUSTRY Co. , Ltd. to obtain a film, a shrinkage percentage of which becomes 0.5% after being heat-treated at 150ºC for 30 minutes.

As the polyester film in which 60% or more of tensile elongation is maintained in both a machine direction and a transverse direction of the film after the film is stored in high-pressure steam of 140ºC for 10 hours, 188 µm X10S (width 1000 mm, length 4000 mm) produced by Toray Industries, Inc. was used and treated at a drying temperature of 160ºC for 20 seconds using a film coater manufactured by OKAZAKI MACHINE INDUSTRY Co., Ltd. to obtain a film, a shrinkage percentage of which becomes 0.5% after being heat-treated at 150ºC for 30 minutes.

A vapor deposited surface of the alumina vapor deposited polyester film was faced toward and bonded to a white polyester film, and to this, 188 µm X10S produced by Toray Industries, Inc. was bonded, and the resulting bonded film was cured and aged for 48 hours in an oven of 40ºC to prepare a backside protection sheet for a solar cell module of Example 4, a shrinkage percentage of which becomes 0.5% after being heat-treated at 150ºC for 30 minutes..

### Comparative Example 1

In order to prepare a transparent alumina vapor deposited polyester film, a biaxially stretched polyethylene terephthalate film T-705 (width 1000 mm, length 4000 mm) having a thickness of 12 µm produced by Toray Industries, Inc. was used, and a vapor deposited film was formed by reactively depositing an aluminum oxide film having a thickness of 20 nm on the film at a processing rate of 100 m/min in a vacuum of 2×10⁻² Pa using a continuous type vacuum vapor deposition apparatus manufactured by ULVAC, Inc. In the reactive deposition of an aluminum oxide film, the ratio (B/A) between an amount [mol/min] of introduced oxygen gas and an average amount A [mol/min] of evaporated aluminum per unit time was set at 0.6, and an alumina vapor deposited PET film having total light transmittance of 98 was formed when the total light transmittance of a PET film (polyethylene terephthalate film) not yet vapor deposited is taken as 100. A shrinkage percentage of the resulting transparent alumina vapor deposited polyester film measured after heat-treating at 150ºC for 30 minutes was 1.2%.

As the polyester film in which 60% or more of tensile elongation is maintained in both a machine direction and a transverse direction of the film after the film is stored in high-pressure steam of 140ºC for 10 hours, 188 µm X10S (width 1000 mm, length 4000 mm) produced by Toray Industries, Inc. was used and treated at a drying temperature of 160QC for 10 seconds using a film coater manufactured by OKAZAKI MACHINE INDUSTRY Co., Ltd. to obtain a film, a shrinkage percentage of which becomes 1.2% after being heat-treated at 150ºC for 30 minutes.

A vapor deposited surface of the transparent alumina vapor deposited polyester film was bonded to a white polyester film not dried by heat with a coater, and to this, 188 µm X10S produced by Toray Industries, Inc. not dried by heat with a coater was bonded, and the resulting bonded film was aged to obtain a film, a shrinkage percentage of which becomes 1.1% after being heat-treated at 150ºC for 30 minutes.

### Comparative Example 2

A backside protection sheet of Comparative Example 2 by following the same procedure as in Comparative Example 1 except that in vapor deposition of an aluminum oxide film of the transparent alumina vapor deposited polyester film, the ratio (B/A) between an amount [mol/min] of introduced oxygen gas and an average amount A [mol/min] of evaporated aluminum per unit time was set at 0.7, and an alumina vapor deposited film having total light transmittance of 98 was formed when the total light transmittance of a polyester film not yet vapor deposited is taken as 100.

### Comparative Example 3

A backside protection sheet of Comparative Example 3 by following the same procedure as in Comparative Example 1 except that in vapor deposition of an aluminum oxide film of the transparent alumina vapor deposited polyester film, the ratio (B/A) between an amount [mol/min] of introduced oxygen gas and an average amount A [mol/min] of evaporated aluminum per unit time was set at 0.72, and an alumina vapor deposited film having total light transmittance of 100 was formed when the total light transmittance of a polyester film not yet vapor deposited is taken as 100.

**[Table 1]**

| Evaluation item | Shrinkage percentage after heat-treating at 150ºC for 30 minutes %) | | Total light transmittance of transparent alumina vapor deposited polyester film (%) | Steam permeability (cc/m²·day) | |
|---|---|---|---|---|---|
| | Machine direction | Transverse direction | | Before heat treatment | After heat treatment |
| Example 1 | 0.2 | 0.1 | 98.0 | 0.7 | 0.7 |
| Example 2 | 0.2 | 0.1 | 99.8 | 0.7 | 0.7 |
| Example 3 | 0.2 | 0.1 | 100.0 | 0.7 | 0.9 |
| Example 4 | 0.5 | 0.5 | 98.0 | 0.7 | 0.8 |
| Comparative Example 1 | 1.5 | 1.2 | 98.0 | 0.7 | 1.8 |
| Comparative Example 2 | 1.5 | 1.2 | 99.8 | 0.7 | 2.1 |
| Comparative Example 3 | 1.5 | 1.2 | 100.0 | 0.7 | 3.9 |

From Table 1, it is evident that in the backside protection sheet for a solar cell of the present invention, the shrinkage percentage after heat treatment at 150ºC for 30 minutes is as small as 0.5% or less in both a machine direction and a transverse direction and the reduction in the steam permeability is very small.

The backside protection sheet for a solar cell of the present invention has a very small reduction in the steam permeability after this sheet is integrated into a solar cell module and therefore it can prevent the reduction in power generation quantity due to a moisture effect.

## Claims

1. A backside protection sheet for a solar cell module comprising a stacked material formed by successively stacking an alumina vapor deposited polyester film, a white polyester film and a polyester film in which 60% or more of tensile elongation is maintained in both a machine direction and a transverse direction of the film after the film is stored in high-pressure steam of 140ºC for 10 hours, wherein a shrinkage percentage of said backside protection sheet at a time of heat-treating at 150ºC for 30 minutes is 0.5% or less in both a machine direction and a transverse direction.

2. The backside protection sheet for a solar cell module according to claim 1, wherein an increase rate of the steam permeability of said protection sheet between before a heat treatment performed at 150ºC for 30 minutes and after the heat treatment is less than 30%.

3. The backside protection sheet for a solar cell module according to claim 1, wherein the total light transmittance of an alumina vapor deposited polyester film is 99.8 or less when the total light transmittance of a polyester film not yet vapor deposited is taken as 100.

4. The backside protection sheet for a solar cell module according to claim 1, wherein a reflection factor of a white polyester film at a wavelength λ of 550 nm is 30% or more.

5. The backside protection sheet for a solar cell module according to claim 1, wherein steam permeability of an alumina vapor deposited polyester film at a temperature of 40ºC and at a relative humidity of 90% is 1.5 g/m²·day or less.

6. A method of producing the backside protection sheet for a solar cell module according to any one of claims 1 to 5, wherein an aluminum oxide film of the alumina vapor deposited polyester film is produced under the condition in which the ratio (B/A) of an amount [mol/min] of introduced oxygen gas and an average amount A [mol/min] of evaporated aluminum per unit time is 0.6 or more and 0.72 or less (0.6 = B/A = 0.72).
